(19) Europäisches Patentamt / European Patent Office / Office européen des brevets

(11) **EP 3 204 964 B1**

(12) **FASCICULE DE BREVET EUROPEEN**

(45) Date de publication et mention
de la délivrance du brevet:
**22.08.2018 Bulletin 2018/34**

(21) Numéro de dépôt: **15771649.9**

(22) Date de dépôt: **02.10.2015**

(51) Int Cl.:
*H01L 31/101* *(2006.01)*     *H02K 29/10* *(2006.01)*

(86) Numéro de dépôt international:
**PCT/EP2015/072801**

(87) Numéro de publication internationale:
**WO 2016/055369 (14.04.2016 Gazette 2016/15)**

(54) **TRANSISTOR À EFFET PHOTOVOLTAÏQUE ET MOTEUR PHOTOVOLTAÏQUE À PUISSANCE AUGMENTÉE ASSOCIÉ**

TRANSISTOR MIT PHOTOVOLTAISCHEM EFFEKT UND ANGESCHLOSSENER PHOTOVOLTAIKMOTOR MIT ERHÖHTER LEISTUNG

PHOTOVOLTAIC-EFFECT TRANSISTOR AND CONNECTED PHOTOVOLTAIC MOTOR HAVING INCREASED POWER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.10.2014 FR 1459605**

(43) Date de publication de la demande:
**16.08.2017 Bulletin 2017/33**

(73) Titulaire: **Coty, Alain**
**95450 Sagy (FR)**

(72) Inventeur: **Coty, Alain**
**95450 Sagy (FR)**

(74) Mandataire: **Ipside**
**29, rue de Lisbonne**
**75008 Paris (FR)**

(56) Documents cités:
**EP-A2- 0 177 275     WO-A1-2012/069447**
**US-A- 5 705 807**

## Description

### Domaine de l'invention

La présente invention concerne un transistor à effet photovoltaïque ainsi qu'un moteur photovoltaïque à puissance augmentée associé.

L'invention se situe dans le domaine de l'optronique et trouve une application particulièrement avantageuse pour les dispositifs passifs qui ne nécessitent aucun composant d'usure.

### Etat de la technique

De manière conventionnelle, et exclusive, les cellules photovoltaïques sont utilisées pour produire de l'énergie électrique. Ces cellules photovoltaïques se comportent comme des photopiles délivrant un courant continu proportionnel à l'éclairement auquel elles sont soumises. La face supérieure, exposée à la lumière, constitue la cathode (pôle de signe moins), et la face opposée joue le rôle d'anode (pôle de signe plus).

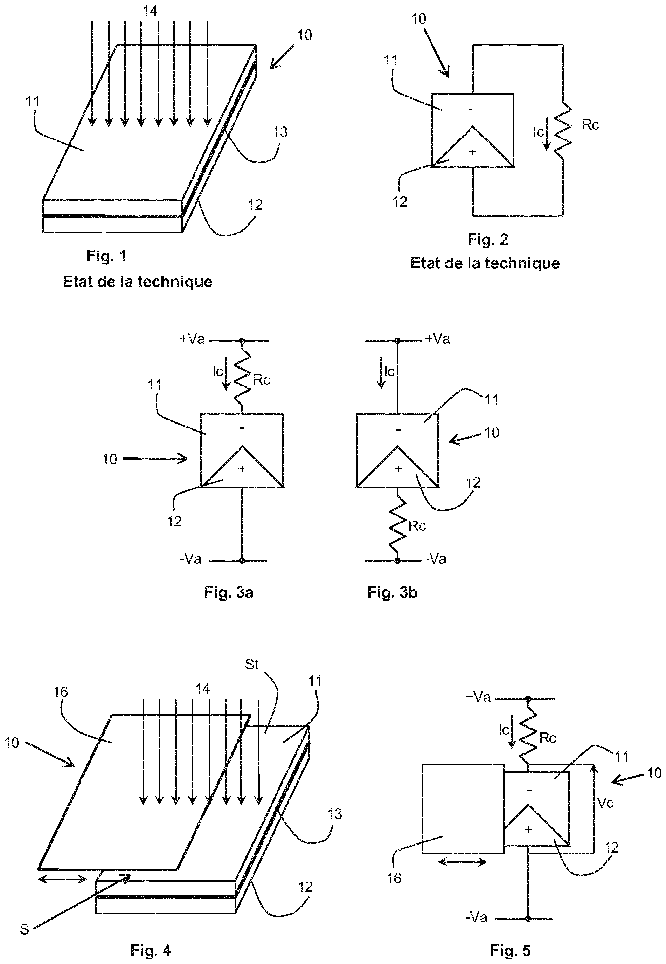

Les Figures 1 et 2 de l'état de la technique illustrent une cellule photovoltaïque 10 comportant une cathode 11 et une anode 12 reliées par une jonction 13. Lorsque que le cellule photovoltaïque 10 est éclairée par une lumière 14, et qu'une charge Rc est connectée à ses bornes, un courant continu Ic circule dans la charge Rc. Le plus fréquemment, cette charge Rc est, soit un moteur électrique fonctionnant directement sur le courant continu, soit un moteur alternatif, par l'intermédiaire d'un onduleur convertissant le courant continu en courant alternatif, soit une batterie permettant de restituer l'énergie électrique en l'absence de soleil, soit encore un convertisseur injectant du courant alternatif dans le réseau.

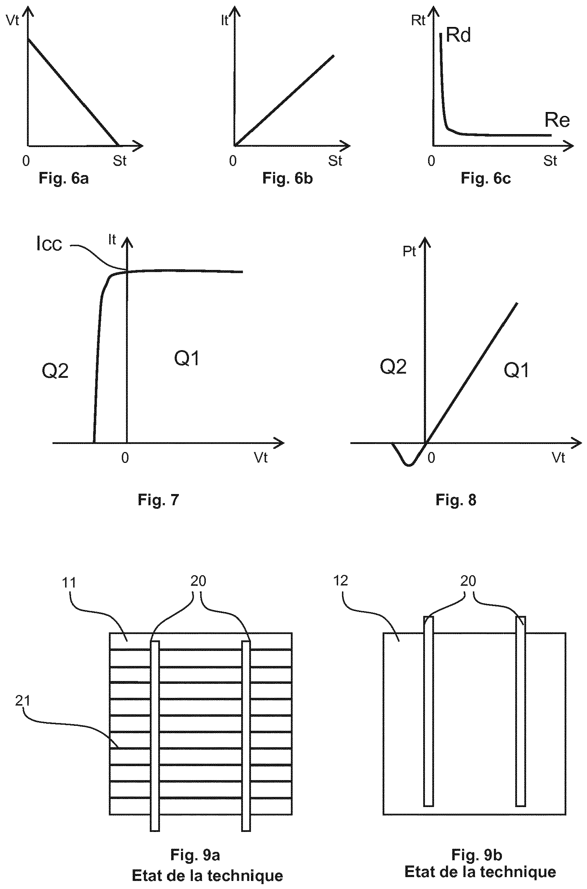

De manière conventionnelle l'anode 12 d'une cellule photovoltaïque 10 est électriquement raccordée au moyen de rubans de cuivre 20 soudés sur de minces pistes argentées 21 tel que représenté sur les Figures 9a et 9b, puis la cellule photovoltaïque 10 est collée sur une plaque isolante électriquement et peu conductrice de la chaleur ; c'est ainsi qu'industriellement sont constitués les panneaux solaires.

Outre ce fonctionnement classique des cellules photovoltaïques, la demande de brevet internationale N°WO 2012/069447 ainsi que la publication scientifique "Photovoltaic transistors based on a steady-state internal polarization effect in asymmetric semiconductor superlattices, Chun-Ting Liu and Serge Luryi, Appli. Phys. Lett., Vol. 59, No. 4, 22 July 1991" décrivent l'utilisation d'un transistor à effet de champ associé à une cellule photovoltaïque. Le transistor à effet de champ est utilisé en commutation entre deux états : un état bloqué lorsqu'il n'y a pas de lumière et un état saturé lorsqu'il y a suffisamment de lumière.

Cependant, cette technologie nécessite d'utiliser deux composants associés : une cellule photovoltaïque et un transistor à effet de champ. En outre, les transistors à effet de champ présentent un vieillissement beaucoup plus important que les cellules photovoltaïques ce qui limite leurs utilisations dans des dispositifs autonomes et à très faible maintenance. Le document EP 0 177 275 A2 décrit un capteur photovoltaïque utilisable comme capteur d'images, dans lequel un photodétecteur est soumis à une tension qui permet de faire circuler un courant dans une charge électrique, ce courant étant fonction d'un éclairement incident sur le photodétecteur.

Le document US 5 705 807 A divulgue un capteur photoélectrique comprenant un photodétecteur.

### Exposé de l'invention

La présente invention vise à remédier aux inconvénients de l'art antérieur en proposant de reproduire le comportement d'un transistor à l'aide d'une seule cellule photovoltaïque câblée en inverse.

A cet effet, selon un premier aspect, l'invention concerne un transistor à effet photovoltaïque, apte à commuter un courant de forte amplitude, comportant une cellule photovoltaïque munie d'une cathode et d'une anode reliées par une jonction, ainsi qu'une surface d'éclairement, ladite cellule photovoltaïque étant soumise à une tension, le plus haut niveau de tension étant relié à la cathode et le plus bas niveau de tension étant relié à l'anode, des moyens pour faire circuler un courant dans une charge reliée à ladite cellule photovoltaïque, ledit courant étant proportionnel à un éclairement de ladite cellule photovoltaïque, à l'aire d'une surface éclairée de la surface d'éclairement et à un facteur traduisant le rendement de ladite cellule photovoltaïque sous un éclairement de référence lorsque toute sa surface d'éclairement est éclairée, ladite cellule photovoltaïque étant insérée entre le générateur de tension et la charge. L'invention permet ainsi de reproduire les caractéristiques d'un transistor à jonction polarisé en fonction de la lumière qu'il reçoit. Ce mode de fonctionnement particulièrement contre intuitif d'une cellule photovoltaïque permet d'obtenir les propriétés électriques d'un transistor, dit à effet photovoltaïque, et d'éliminer les problèmes d'usure des composants traditionnels.

Selon un mode de réalisation, le produit de l'éclairement de ladite cellule photovoltaïque et de ladite surface éclairée représente un courant circulant dans la base d'un transistor à jonction. Ce mode de réalisation permet de retrouver le courant de base d'un transistor à jonction classique.

Selon un mode de réalisation, le facteur, traduisant le rendement de ladite cellule photovoltaïque sous un éclairement de référence lorsque toute sa surface d'éclairement est éclairée, est assimilé à un gain d'un transistor à jonction. Ce mode de réalisation permet de retrouver le gain d'un transistor à jonction classique.

Selon un mode de réalisation, le transistor à effet photovoltaïque comporte un obturateur de la surface d'éclairement apte à modifier l'aire de ladite surface éclairée. De la même manière qu'un transistor à jonction, le transistor à effet photovoltaïque peut fonctionner, en tout ou rien, comme un simple interrupteur capable de commuter quasiment instantanément le courant Ic circulant dans la charge Rc. Dans cette application, la surface de la cathode demeurant constante, le passage de l'obscurité à l'éclairement est obtenu soit par un obturateur opaque mobile à déplacement rapide, soit par une source lumineuse à éclat (également appelé "flash" dans la littérature anglo-saxonne).

Selon un mode de réalisation, l'anode du transistor à effet photovoltaïque est fixée, par toute sa surface, sur une feuille métallique conductrice au moyen d'une colle conductrice.

Selon un mode de réalisation, ladite colle est constituée d'une résine organique à forte teneur en poudre métallique, par exemple une colle fortement chargée en cuivre. Ce mode de réalisation permet d'obtenir une excellente conductivité électrique et thermique.

Selon un mode de réalisation, ladite feuille métallique conductrice est une feuille de cuivre ou un feuillard de fer-nickel. Le support en cuivre laminé sur un substrat en verre-époxyde électriquement isolant est industriellement employé pour la fabrication des circuits imprimés destinés à recevoir des composants électroniques. Pour une fabrication plus précise, il est possible de parfaire la liaison mécanique entre le transistor à effet photovoltaïque et son support en remplaçant la feuille de cuivre par un feuillard de fer-nickel dont le coefficient de dilatation thermique est proche de celui du silicium avec lequel est fabriqué le transistor à effet photovoltaïque.

Selon un mode de réalisation, le transistor à effet photovoltaïque comporte un substrat électriquement isolant collé sur une semelle en alliage d'aluminium. Ce mode de réalisation permet de favoriser la dissipation thermique du transistor à effet photovoltaïque.

Selon un mode de réalisation, le transistor à effet photovoltaïque comporte une couche de protection en résine polyépoxyde. Ce mode de réalisation permet de protéger le transistor à effet photovoltaïque des agressions mécaniques et climatiques.

Selon un second aspect, l'invention concerne un moteur photovoltaïque comportant un stator comprenant des bobines formant les phases du moteur, un rotor positionné à l'intérieur du stator, une source de tension réalisée à partir de cellules photovoltaïques, un circuit de commutation composé d'au moins deux transistors à effet photovoltaïque selon le premier aspect de l'invention, et un disque obturateur lié en rotation avec le rotor comportant une fenêtre apte à éclairer séquentiellement les transistors à effet photovoltaïque.

## Brève description des dessins

On comprendra mieux l'invention à l'aide de la description, faite ci-après à titre purement explicatif, des modes de réalisation de l'invention, en référence aux Figures dans lesquelles :

- la Figure 1 (état de la technique) illustre une représentation schématique d'une cellule photovoltaïque ;
- la Figure 2 (état de la technique) illustre une représentation électrique d'une cellule photovoltaïque connectée à une charge ;
- la Figure 3 illustre une représentation électrique du transistor à effet photovoltaïque selon un premier mode de réalisation de l'invention (Figure 3a : charge sur la cathode, Figure 3b : charge sur l'anode) ;
- la Figure 4 illustre une représentation schématique du transistor à effet photovoltaïque selon un deuxième mode de réalisation de l'invention ;
- la Figure 5 illustre une représentation électrique du transistor à effet photovoltaïque connecté à une charge sur la cathode selon le mode de réalisation de la Figure 4 ;
- la Figure 6a illustre une représentation schématique graphique des variations de la tension du transistor à effet photovoltaïque de la Figure 4 en fonction de la surface éclairée ;
- la Figure 6b illustre une représentation schématique graphique des variations du courant du transistor à effet photovoltaïque de la Figure 4 en fonction de la surface éclairée ;
- la Figure 6c illustre une représentation schématique graphique des variations de la résistance interne du transistor à effet photovoltaïque de la Figure 4 en fonction de la surface éclairée ;
- la Figure 7 illustre une représentation schématique graphique des variations du courant du transistor à effet photovoltaïque de la Figure 4 en fonction de la tension ;
- la Figure 8 illustre une représentation schématique graphique des variations de la puissance du transistor à effet photovoltaïque de la Figure 4 en fonction de la tension ;
- la Figure 9 (état de la technique) illustre une représentation schématique d'une cellule photovoltaïque (Figure 9a : vue de dessus, Figure 9b : vue de dessous) ;
- la Figure 10 illustre le transistor à effet photovoltaïque de la Figure 4 dans une vue de dessus ;
- la Figure 11 illustre une représentation schématique d'un transistor à effet photovoltaïque selon un troisième mode de réalisation (Figure 11a, vue de dessous, Figure 11b, vue de dessus et Figure 11c, vue en coupe latérale) ; et
- la Figure 12 illustre une représentation schématique d'un moteur photovoltaïque selon un premier mode de réalisation.

## Description détaillée des modes de réalisation de l'invention

La Figure 3a illustre une cellule photovoltaïque 10 fonctionnant comme un transistor lorsque la cellule photovoltaïque 10 est insérée entre un générateur de tension et une charge Rc jouant le rôle de récepteur. La cathode 11 est reliée au pôle positif +Va d'une source de tension Va au travers de la charge Rc, l'anode 12 est, quant à elle, connectée au pôle négatif -Va de cette même source Va. De manière évidente, la charge Rc peut être appliquée indifféremment à la cathode 11 ou à l'anode 12. Dans le mode de réalisation de la Figure 3b, la charge Rc est appliquée à l'anode 12.

Dans ces configurations, pour une tension d'alimentation Va et une charge Rc données, le courant Ic, circulant dans la charge, est proportionnel à l'éclairement Pe (en W/m$^2$), à l'aire de la surface St (en m$^2$) éclairée, et à un facteur $\beta$ traduisant le rendement de la cellule photovoltaïque 10 sous un éclairement de références (p. ex 1000 W/m$^2$) lorsque toute sa surface est éclairée. Le produit Pe * St joue le même rôle que le courant circulant dans la base d'un transistor à jonction, et le facteur $\beta$ peut être assimilé à un gain. Dans cette configuration particulièrement contre intuitive, la cellule photovoltaïque 10 reproduit ainsi le fonctionnement d'un transistor pour lequel les transitions sont induites par un effet photovoltaïque. Ce mode de fonctionnement d'une cellule photovoltaïque sera appelé transistor à effet photovoltaïque.

De la même manière qu'un transistor à jonction, un transistor à effet photovoltaïque 30 peut fonctionner, en tout ou rien, comme un simple interrupteur capable de commuter quasiment instantanément le courant Ic circulant dans la charge Rc. Dans cette application, la surface d'éclairement S de la cathode demeurant constante, le passage de l'obscurité à l'éclairement est obtenu soit par un obturateur opaque mobile à déplacement rapide, soit par une source lumineuse à éclat (également appelé "flash" dans la littérature anglo-saxonne).

Selon les Figures 4 et 5, une autre façon d'utiliser le transistor à effet photovoltaïque 30 consiste, sous un éclairement constant, à faire varier progressivement l'aire de la surface éclairée St en déplaçant un écran opaque 16 entre la cathode 11 et la source lumineuse 14. Le courant Ic étant proportionnel à l'aire de la surface éclairée St, une variation du courant Ic en fonction du déplacement de l'écran 16 se manifeste dans la charge Rc.

La mesure de la tension Vc aux bornes du transistor à effet photovoltaïque, et du courant Icen circulant dans le transistor à effet photovoltaïque 30 en fonction de la surface éclairée St, permet de tracer deux graphes linéaires : le premier est représenté sur la Figure 6a et traduit la variation de la tension Vt(St) = a * St + b, le second est illustré sur la Figure 6b et représente la variation simultanée du courant It(St) = c * St + d. Le rapport Vc/Ic entre ces deux fonctions linéaires est tracé sur la Figure 6c et révèle une fonction homographique

$$Rt(St) = \frac{a*St+b}{c*St+d}$$

ayant la dimension d'une résistance. Pour cette raison, Rt est considéré comme une « résistance interne du transistor à effet photovoltaïque».

La Figure 6c illustre les variations de la résistance interne en fonction de la surface éclairée St. La résistance interne varie entre une résistance d'obscurité Rd et une résistance d'éclairement maximal Re. La résistance Rd est particulièrement aisée à mesurer puisqu'elle ne dépend pas de l'éclairement. En outre, cette résistance Rd permet de caractériser la qualité de fabrication du transistor à effet photovoltaïque. Une valeur trop élevée de Rd (voire infinie) témoigne d'un raccordement défectueux du transistor à effet photovoltaïque, et, au contraire, lorsque Rd est trop faible, cela indique une mise en court-circuit (partiel) lors de la fabrication du transistor à effet photovoltaïque. La résistance Re, quant à elle, caractérise la capacité du transistor à effet photovoltaïque 30 à se laisser traverser par un courant d'amplitude importante tout en ne présentant qu'une faible résistance au passage de ce courant. Plus Re est faible, moins la puissance dissipée dans le transistor à effet photovoltaïque 30 est élevée, et meilleur est le rendement de la commutation.

La Figure 7 illustre la variation du courant Ic, non plus en fonction de l'aire de la surface éclairée St, mais de la chute de tension Vc lorsque la totalité de la surface S du transistor à effet photovoltaïque 30 est sous un éclairement constant. Les variations du courant Ic peuvent être décrite par une équation de la forme It(Vt) = Icc + Id * (e$^{k*Vt}$ - 1), où Icc correspond à un courant de court-circuit puisque, pour cette valeur, la tension aux bornes du transistor à effet photovoltaïque 30 est nulle. Ainsi, sur la Figure 7, deux zones apparaissent de part et d'autre du courant dit de « court-circuit ». La première, située dans le premier quadrant Q1, montre un fonctionnement purement dissipatif du transistor à effet photovoltaïque. Le courant It y est quasiment constant malgré une variation importante de la tension Vc. Il en résulte une variation linéaire et importante de la puissance dissipée dans le transistor à effet photovoltaïque 30 tel que décrit sur la Figure 8. A contrario, le second quadrant Q2 révèle un fonctionnement en générateur. Le courant Ic croît très rapidement, mais la tension (négative) conserve une faible amplitude. Cela signifie que, dans ce second quadrant Q2, la puissance dissipée par le transistor à effet photovoltaïque 30 est constamment faible, et contribue peu à son échauffement. La valeur négative de la puissance dissipée confirme le fait que le transistor à effet photovoltaïque 30 fonctionne en générateur.

Afin d'éviter au transistor à effet photovoltaïque 30 un échauffement préjudiciable au bon fonctionnement du transistor à effet photovoltaïque, il est souhaitable de dimensionner la charge Rc, et d'ajuster la tension d'alimentation Va, de manière à faire fonctionner le transistor à effet photovoltaïque 30 dans le second quadrant Q2, ou au tout début du premier quadrant Q1.

Afin de contribuer à diminuer l'échauffement du transistor à effet photovoltaïque, la présente invention concerne également un procédé de réalisation ayant pour but de prélever le courant et d'évacuer la chaleur sur toute la surface de l'anode 12.

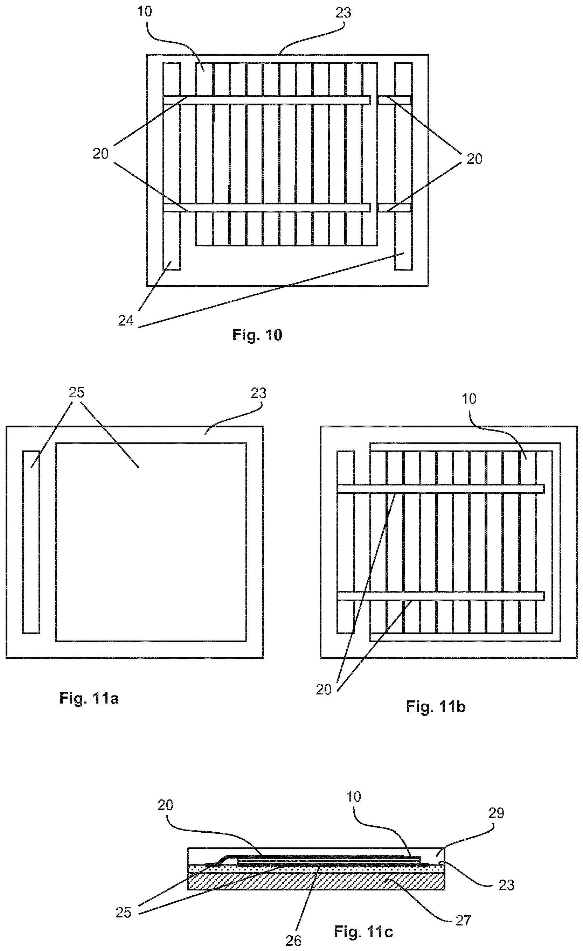

Tel que représenté sur les Figures 11a, 11b et 11c, l'anode 12 du transistor à effet photovoltaïque 30 est intimement fixée, par toute sa surface, sur une mince feuille métallique conductrice 25 au moyen d'une colle 26, elle aussi, conductrice de l'électricité. Afin d'obtenir une excellente conductivité électrique et thermique, cette colle 26 est constituée d'une résine organique à très forte teneur en poudre métallique extrêmement fine. Parmi toutes les colles conductrices, disponibles dans le commerce, il est préférable d'employer une colle 26 fortement chargée en cuivre. Ceci, d'autant que la surface métallique est constituée d'une feuille de cuivre laminée sur un substrat 23 en verre-époxyde électriquement isolant. Ce support est industriellement employé pour la fabrication des circuits imprimés destinés à recevoir des composants électroniques. Quoique de fabrication plus onéreuse, il est possible de parfaire la liaison mécanique entre le transistor à effet photovoltaïque 30 et son support en remplaçant la feuille de cuivre 25 par un feuillard de fer-nickel dont le coefficient de dilatation thermique est proche de celui du silicium avec lequel est fabriqué le transistor à effet photovoltaïque.

Pour encore favoriser la dissipation thermique, le substrat électriquement isolant 23 est collé sur une semelle 27 en alliage d'aluminium bon conducteur de la chaleur.

De manière identique aux cellules photovoltaïques, la capture du courant à la cathode s'effectue aux moyens de minces rubans en cuivre 20 dont la largeur et le nombre résultent d'un compromis entre la nécessité de laisser le maximum de lumière, et une densité de courant prohibitive dans les rubans 20. Les rubans de cuivre 20 sont soudés sur de minces pistes argentées 21 et reliés à des bandes collectrices 24.

Après le collage de l'anode 12, et le raccordement des rubans 20 de la cathode 11, le transistor à effet photovoltaïque 30 est protégé des agressions mécaniques et climatiques par une résine polyépoxyde 29 dont il est éprouvé que la transparence, à la lumière visible, est peu affectée par le temps. Après dégazage, la résine polyépoxyde 29 est déposée, sous vide, en une couche de faible épaisseur, puis maintenue à l'abri de toute contamination atmosphérique jusqu'à sa totale polymérisation.

De la même façon qu'un transistor conventionnel, le transistor à effet photovoltaïque 30 peut être employé pour la commutation de signaux faibles. Ce n'est toutefois pas la meilleure utilisation qui puisse en être faite puisque l'une des caractéristiques du transistor à effet photovoltaïque 30 est, précisément, de pouvoir commuter des courants de forte amplitude. A titre d'exemple, un transistor à effet photovoltaïque, réalisé à partir d'une cellule photovoltaïque de 156x156 mm, peut commuter un courant de 9 A, sous un éclairement standard de 1000 W/m$^2$. Ainsi, le transistor à effet photovoltaïque 30 peut être appliqué à la commutation du courant circulant dans les enroulements d'un moteur électrique de plusieurs centaines de Watt.

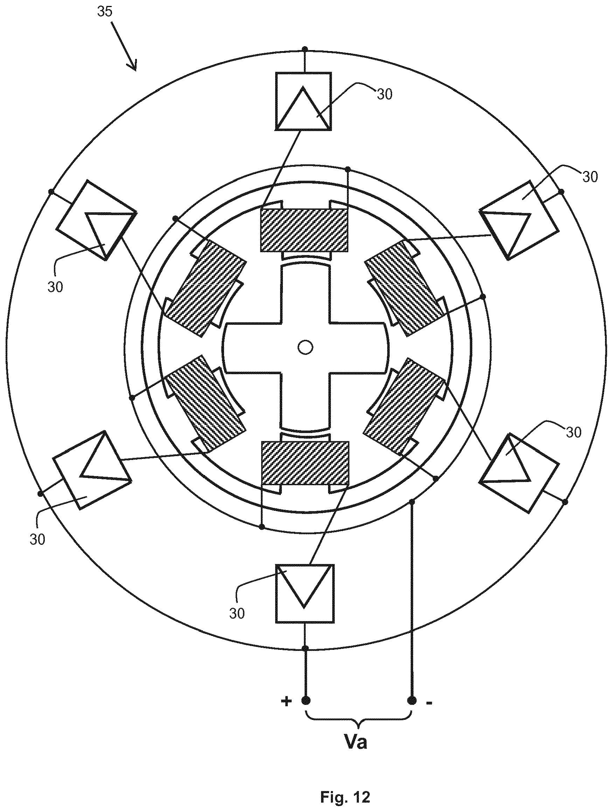

Le meilleur exemple en est le Moteur Photovoltaïque Autocommuté 35 (présenté dans la demande de brevet internationale N°WO 2012/069447). Ce moteur 35, sans aimants, ne nécessite aucun autre dispositif de commutation mécanique ou électronique que les transistors à effet photovoltaïque 30. Ces transistors à effet photovoltaïque 30 sont disposés, en couronne autour du moteur selon le schéma de raccordement représenté à la Figure 12 et la commutation de la source Va pour les différents enroulements du stator est effectuée par un disque obturateur lié en rotation avec le rotor. Le disque obturateur comporte une fenêtre apte à éclairer séquentiellement les transistors à effet photovoltaïque 30. S'agissant d'un moteur destiné à fonctionner au soleil, la source de tension Va est naturellement constituée d'un panneau photovoltaïque.

## Revendications

1. Transistor à effet photovoltaïque (30), apte à commuter un courant de forte amplitude, comportant :

   - une cellule photovoltaïque (10) munie d'une cathode (11) et d'une anode (12) reliées par une jonction (13), ainsi qu'une surface d'éclairement (S),
   - ladite cellule photovoltaïque (10) étant soumise à une tension (Va), le plus haut niveau de tension (+Va) étant relié à la cathode (11) et le plus bas niveau de tension (-Va) étant relié à l'anode (12),
   - des moyens pour faire circuler un courant (Ic) dans une charge (Rc) reliée à ladite cellule photovoltaïque (10), ledit courant (Ic) étant proportionnel à un éclairement (Pe) de ladite cellule photovoltaïque (10), à l'aire d'une surface éclairée (St) de la surface d'éclairement (S) et à un facteur (β) traduisant le rendement de ladite cellule photovoltaïque (10) sous un éclairement de référence lorsque toute sa surface d'éclairement (S) est éclairée, ladite cellule photovoltaïque (10) étant insérée entre le générateur de tension (Va) et la charge (Rc).

2. Transistor à effet photovoltaïque selon la revendication 1, **caractérisé en ce qu'**il comporte un obturateur (16) de la surface d'éclairement (S) apte à modifier l'aire de ladite surface éclairée (St).

3. Transistor à effet photovoltaïque selon la revendication 1 ou 2, **caractérisé en ce que** le produit de l'éclairement (Pe) de ladite cellule photovoltaïque (10) et de ladite surface éclairée (St) représente un courant circulant dans la base d'un transistor à jonction.

4. Transistor à effet photovoltaïque selon l'une des revendications 1 à 3, **caractérisé en ce que** le facteur (β), traduisant le rendement de ladite cellule photovoltaïque (10) sous un éclairement de références lorsque toute sa surface d'éclairement (S) est éclairée, est assimilé à un gain d'un transistor à jonction.

5. Transistor à effet photovoltaïque selon l'une des revendications 1 à 4, **caractérisé en ce que** l'anode (12) du transistor à effet photovoltaïque (30) est fixée, par toute sa surface, sur une feuille métallique conductrice (25) au moyen d'une colle (26) conductrice.

6. Transistor à effet photovoltaïque selon la revendication 5, **caractérisé en ce que** ladite colle (26) est constituée d'une résine organique à forte teneur en poudre métallique, par exemple une colle (26) fortement chargée en cuivre.

7. Transistor à effet photovoltaïque selon la revendication 5 ou 6, **caractérisé en ce que** ladite feuille métallique conductrice (25) est une feuille de cuivre ou un feuillard de fer-nickel.

8. Transistor à effet photovoltaïque selon l'une des revendications 1 à 7, **caractérisé en ce qu'**il comporte un substrat électriquement isolant (23) collé sur une semelle (27) en alliage d'aluminium.

9. Transistor à effet photovoltaïque selon l'une des revendications 1 à 8, **caractérisé en ce qu'**il comporte une couche de protection en résine polyépoxyde (29).

10. Moteur photovoltaïque (35) comportant :

    - un stator comprenant des bobines formant les phases du moteur,
    - un rotor positionné à l'intérieur du stator,
    - une source de tension (Va) réalisée à partir de cellules photovoltaïques,
    - un circuit de commutation composé d'au moins deux transistors à effet photovoltaïque (30) selon l'une des revendications 1 à 9, et
    - un disque obturateur lié en rotation avec le rotor comportant une fenêtre apte à éclairer séquentiellement les transistors à effet photovoltaïque (30).

**Patentansprüche**

1. Transistor mit photovoltaischem Effekt (30), der imstande ist, einen Strom mit starker Amplitude zu schalten, Folgendes aufweisend:

    - eine Photovoltaikzelle (10), die mit einer Kathode (11) und einer Anode (12) versehen ist, die durch eine Sperrschicht (13) verbunden sind, sowie eine Leuchtfläche (S),
    - wobei die Photovoltaikzelle (10) einer Spannung (Va) unterliegt, wobei die höchste Spannungsstufe (+Va) mit der Kathode (11) verbunden ist und die niedrigste Spannungsstufe (-Va) mit der Anode (12) verbunden ist,
    - Mittel, um einen Strom (Ic) in einer Last (Rc) zirkulieren zu lassen, die mit der Photovoltaikzelle (10) verbunden ist, wobei der Strom (Ic) proportional zu einer Beleuchtungsstärke (Pe) der Photovoltaikzelle (10), zur Fläche einer beleuchteten Oberfläche (St) der Leuchtfläche (S) und einem Faktor (ß), der die Leistung der Photovoltaikzelle (10) unter einer Bezugsbeleuchtungsstärke zum Ausdruck bringt, ist, wenn die gesamte Leuchtfläche (S) beleuchtet ist, wobei die Photovoltaikzelle (10) zwischen den Spannungsgenerator (Va) und die Last (Rc) eingeführt wird.

2. Transistor mit photovoltaischem Effekt nach Anspruch 1, **dadurch gekennzeichnet, dass** er einen Verschluss (16) der Leuchtfläche (S) aufweist, die imstande ist, die Fläche der beleuchteten Oberfläche (St) zu verändern.

3. Transistor mit photovoltaischem Effekt nach dem Anspruch 1 oder 2, **dadurch gekennzeichnet, dass** das Produkt der Beleuchtungsstärke (Pe) der Photovoltaikzelle (10) und der beleuchteten Oberfläche (St) einen Strom repräsentiert, der in der Basis eines Sperrschicht-Transistors zirkuliert.

4. Transistor mit photovoltaischem Effekt nach einem der Ansprüche 1 bis 3, **dadurch gekennzeichnet, dass** der Faktor (ß), der die Leistung der Photovoltaikzelle (10) unter einer Bezugsbeleuchtungsstärke zum Ausdruck bringt, wenn die gesamte Leuchtfläche (S) beleuchtet ist, einer Verstärkung eines Sperrschicht-Transistors gleichgestellt wird.

5. Transistor mit photovoltaischem Effekt nach einem der Ansprüche 1 bis 4, **dadurch gekennzeichnet, dass** die Anode (12) des Transistors mit photovoltaischem Effekt (30) durch ihre gesamte Oberfläche mittels eines leitenden Klebers (26) auf einer leitenden Metallfolie (25) fixiert ist.

6. Transistor mit photovoltaischem Effekt nach Anspruch 5, **dadurch gekennzeichnet, dass** der Kleber (26) aus einem organischen Harz mit einem hohen Gehalt an Metallpulver gebildet wird, wie beispielsweise ein Kleber (26) mit hohem Kupferanteil.

7. Transistor mit photovoltaischem Effekt nach Anspruch 5 oder 6, **dadurch gekennzeichnet, dass** die leitende Metallfolie (25) eine Kupferfolie oder ein Eisen-Nickel-Band ist.

**8.** Transistor mit photovoltaischem Effekt nach einem der Ansprüche 1 bis 7, **dadurch gekennzeichnet, dass** er ein elektrisch isolierendes Substrat (23) aufweist, das auf eine Sohle (27) aus Aluminiumlegierung geklebt ist.

**9.** Transistor mit photovoltaischem Effekt nach einem der Ansprüche 1 bis 8, **dadurch gekennzeichnet, dass** er eine Schutzschicht aus Polyepoxidharz (29) aufweist.

**10.** Photovoltaikmotor (35) aufweisend:

- einen Stator, der Spulen umfasst, die die Phasen des Motors bilden,
- einen Rotor, der im Inneren des Stators positioniert ist,
- eine Spannungsquelle (Va), die aus Photovoltaikzellen realisiert wird,
- einen Schaltkreis, der aus mindestens zwei Transistoren mit photovoltaischem Effekt (30) nach einem der Ansprüche 1 bis 9 zusammengesetzt ist, und
- eine Verschlussscheibe, die drehend mit dem Rotor verbunden ist, ein Fenster aufweisend, das imstande ist, die Transistoren mit photovoltaischem Effekt (30) sequenziell zu beleuchten.

**Claims**

**1.** Photovoltaic-effect transistor (30), able to switch a high amplitude current, comprising:

- a photovoltaic cell (10) provided with a cathode (11) and with an anode (12) interconnected by means of a junction (13), as well as an illumination surface (S),
- said photovoltaic cell (10) having a voltage (Va) applied thereto, the highest voltage level (+Va) being connected to the cathode (11) and the lowest voltage level (-Va) being connected to the anode (12),
- means for having a current (Ic) flow through a load (Rc) connected to said photovoltaic cell (10), said current (Ic) being proportional to an illuminance (Pe) of said photovoltaic cell (10), to the surface area of an illuminated surface (St) of the illumination surface (S) and to a factor ($\beta$) showing the output of said photovoltaic cell (10) under a reference illumination when the entire illumination surface (S) is illuminated, said photovoltaic cell (10) being inserted between the voltage generator (Va) and the load (Rc).

**2.** Photovoltaic-effect transistor according to claim 1, **characterised in that** it comprises a shutter (16) of the illumination surface (S) able to modify the surface area of said illuminated surface (St).

**3.** Photovoltaic-effect transistor according to claim 1 or 2, **characterised in that** the product of the illuminance (Pe) of said photovoltaic cell (10) and of said illuminated surface (St) represents a current flowing in the base of a junction transistor.

**4.** Photovoltaic-effect transistor according to one of claims 1 to 3, **characterised in that** the factor ($\beta$), showing the output of said photovoltaic cell (10) under a reference illumination when the entire illumination surface (S) is illuminated, is regarded as a gain of a junction transistor.

**5.** Photovoltaic-effect transistor according to one of claims 1 to 4, **characterised in that** the anode (12) of the photovoltaic-effect transistor (30) is fixed, over its entire surface, on a conductive metal sheet (25) by means of a conductive adhesive (26).

**6.** Photovoltaic-effect transistor according to claim 5, **characterised in that** said adhesive (26) is comprised of an organic resin with a high metal powder content, for example an adhesive (26) with a high copper content.

**7.** Photovoltaic-effect transistor according to claim 5 or 6, **characterised in that** said conductive metal sheet (25) is a copper sheet or an iron-nickel strip.

**8.** Photovoltaic-effect transistor according to one of claims 1 to 7, **characterised in that** it comprises an electrically insulating substrate (23) glued onto a sole (27) made of aluminium alloy.

**9.** Photovoltaic-effect transistor according to one of claims 1 to 8, **characterised in that** it comprises a protective layer made of polyepoxide resin (29).

**10.** Photovoltaic motor (35) comprising:

- a stator comprising coils formant the phases of the motor,
- a rotor positioned inside the stator,
- a source of voltage (Va) created using photovoltaic cells,
- a switching circuit comprised of at least two photovoltaic-effect transistors (30) according to one of claims 1 to 9, and
- a shutter disc linked in rotation with the rotor comprising a window able to sequentially illuminate the photovoltaic-effect transistors (30).

**Fig. 1**

Etat de la technique

**Fig. 2**

Etat de la technique

+Va

Ic Rc

-Va

**Fig. 3a**

+Va

Ic

Rc

-Va

**Fig. 3b**

**Fig. 4**

+Va

Ic Rc

Vc

-Va

**Fig. 5**

Fig. 6a

Fig. 6b

Fig. 6c

Fig. 7

Fig. 8

Fig. 9a
Etat de la technique

Fig. 9b
Etat de la technique

Fig. 10

Fig. 11a

Fig. 11b

Fig. 11c

35

30

30

30

30

30

30

+ Va -

**Fig. 12**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2012069447 A
- EP 0177275 A2
- US 5705807 A

**Littérature non-brevet citée dans la description**

- **CHUN-TING LIU ; SERGE LURY.** *Appli. Phys. Lett.,* 22 Juillet 1991, vol. 59 (4